(19) Europäisches Patentamt / European Patent Office / Office européen des brevets

(11) **EP 2 581 756 A1**

## (12) EUROPEAN PATENT APPLICATION

(43) Date of publication:
**17.04.2013 Bulletin 2013/16**

(51) Int Cl.:
***G01R 33/561*** *(2006.01)*

(21) Application number: **11184643.2**

(22) Date of filing: **11.10.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
- **Koninklijke Philips Electronics N.V.**
  **5621 BA Eindhoven (NL)**
- **Philips Intellectual Property & Standards GmbH**
  **20099 Hamburg (DE)**

(72) Inventors:
- **Forthmann, Peter**
  **5600 AE Eindhoven (NL)**

- **Brink Van Den, Johan, S.**
  **5600 AE Eindhoven (NL)**
- **Harvey, Paul, R.**
  **5600 AE Eindhoven (NL)**
- **Leussler, Christoph**
  **5600 AE Eindhoven (NL)**
- **Vernickel, Peter**
  **5600 AE Eindhoven (NL)**
- **Wuelbern, Jan Hendrik**
  **5600 AE Eindhoven (NL)**
- **Graesslin, Ingmar**
  **5600 AE Eindhoven (NL)**

(74) Representative: **Damen, Daniel Martijn**
**Philips Intellectual Property & Standards**
**P.O. Box 220**
**5600 AE  Eindhoven (NL)**

(54) **MR imaging using parallel signal acquisition**

(57)     The invention relates to a method of MR imaging of at least an object (10) placed in an examination volume of a MR device (1). The method comprises the steps of:
- subjecting the object (10) to a first imaging sequence for acquiring a first signal data set (19), which first signal data set (19) includes MR signals received via a volume RF coil (9) having an essentially homogeneous spatial sensitivity profile within the examination volume, wherein the first imaging sequence comprises RF pulses and switched magnetic field gradients controlled in such a manner that only a central portion of k-space is sampled at a full sampling density;
- subjecting the object (10) to a second imaging sequence for acquiring a second signal data set (20, 21, 22), which second signal data set (20, 21, 22) includes MR signals received in parallel via a set of at least two array RF coils (11, 12, 13) having different spatial sensitivity profiles within the examination volume, wherein the second imaging sequence comprises RF pulses and switched magnetic field gradients controlled in such a manner that peripheral and central portions of k-space are sampled at a reduced sampling density;
- deriving a set of weights from the first signal data (19) set and the second signal data set (20, 21, 22);
- applying the set of weights for combining the MR signals received via the at least two array RF coils (11, 12, 13) into a third signal data set (25) in such a manner that the third signal data set (25) covers the peripheral and central portions of k-space at the full sampling density; and
- reconstructing a MR image (27) from the third signal data set (25). Moreover, the invention relates to a MR device for carrying out this method as well as to a computer program to be run on a MR device.

Fig. 2

**Description**

FIELD OF THE INVENTION

The invention relates to the field of magnetic resonance (MR) imaging. It concerns a method of MR imaging of an object. The invention also relates to a MR device and to a computer program to be run on a MR device.

BACKGROUND OF THE INVENTION

Image-forming MR methods which utilize the interaction between magnetic fields and nuclear spins in order to form two-dimensional or three-dimensional images are widely used nowadays, notably in the field of medical diagnostics, because for imaging of soft tissue they are superior to other imaging methods in many respects, do not require ionizing radiation and are usually not invasive.

SUMMARY OF THE INVENTION

According to the MR method in general, the object, for example the body of the patient to be examined, is arranged in a strong, uniform magnetic field whose direction at the same time defines an axis (normally the z-axis) of the co-ordinate system on which the measurement is based. The magnetic field produces different energy levels for the individual nuclear spins in dependence on the magnetic field strength which can be excited (spin resonance) by application of an electromagnetic alternating field (RF field) of defined frequency (so-called Larmor frequency, or MR frequency). From a macroscopic point of view the distribution of the individual nuclear spins produces an overall magnetization which can be deflected out of the state of equilibrium by application of an electromagnetic pulse of appropriate frequency (RF pulse), so that the magnetization performs a precessional motion about the z-axis. The precessional motion describes a surface of a cone whose angle of aperture is referred to as flip angle. The magnitude of the flip angle is dependent on the strength and the duration of the applied electromagnetic pulse. In the case of a so-called 90° pulse, the spins are deflected from the z axis to the transverse plane (flip angle 90°).

After termination of the RF pulse, the magnetization relaxes back to the original state of equilibrium, in which the magnetization in the z direction is built up again with a first time constant $T_1$ (spin lattice or longitudinal relaxation time), and the magnetization in the direction perpendicular to the z direction relaxes with a second time constant $T_2$ (spin-spin or transverse relaxation time). The variation of the magnetization can be detected by means of receiving RF coils which are arranged and oriented within an examination volume of the MR device in such a manner that the variation of the magnetization is measured in the direction perpendicular to the z-axis.

The decay of the transverse magnetization is accompanied, after application of, for example, a 90° pulse, by a transition of the nuclear spins (induced by local magnetic field inhomogeneities) from an ordered state with the same phase to a state in which all phase angles are uniformly distributed (dephasing). The dephasing can be compensated by means of a refocusing pulse (for example a 180° pulse). This produces an echo signal (spin echo) in the receiving coils.

To realize spatial resolution in the body, constant magnetic field gradients extending along the three main axes are superposed on the uniform magnetic field, leading to a linear spatial dependency of the spin resonance frequency. The signal picked up in the receiving coils then contains components of different frequencies which can be associated with different locations in the body. The signal data obtained via the receiving coils corresponds to the spatial frequency domain and is called k-space data. The k-space data usually includes multiple lines acquired with different phase encoding. Each line is digitized by collecting a number of samples. A set of k-space data is converted to a MR image by means of an image reconstruction algorithm.

Recently, techniques for accelerating MR acquisition have been developed which are called parallel acquisition. Methods in this category are SENSE (Sensitivity Encoding), SMASH (Simultaneous Acquisition of Spatial Harmonics), and GRAPPA (Generalized Auto-calibrating Partially Parallel Acquisition). SENSE, SMASH, and GRAPPA and other parallel acquisition techniques use undersampled k-space data acquisition obtained from multiple RF receiving coils in parallel. In these methods, the (complex) signal data from the multiple coils are combined with complex weightings in such a way as to suppress undersampling artifacts (aliasing) in the finally reconstructed MR images. This type of complex array signal combination is sometimes referred to as spatial filtering, and includes combining which is performed in the k-space domain (as in SMASH and GRAPPA) or in the image domain (as in SENSE), as well as methods which are hybrids.

In SENSE, coil sensitivity profiles are estimated from low-resolution calibration images or data . This coil sensitivity information are then used to "unwrap" aliased pixels in image space using a direct inversion algorithm. GRAPPA falls into the category of auto-calibrating parallel MR imaging. In GRAPPA, a set of weights is calculated, which is necessary to synthesize k-space data which is missing (due to under-sampling) from acquired k-space data using an algorithm that does not require coil sensitivity estimates. The set of weights for GRAPPA is calculated from a small amount of fully sampled calibration data that is typically embedded within the acquisition of the under-sampled signal data. Auto-calibrating parallel imaging approaches are typically preferred in cases in which accurate coil sensitivity estimates cannot be obtained. Moreover, auto-calibrating parallel imaging techniques are known to exhibit a small amount of image artifacts in the finally reconstructed MR images.

One drawback of GRAPPA and similar k-space based reconstruction schemes is that they are computationally demanding. In conventional GRAPPA reconstruction, a complete (i.e. fully sampled) signal data set is synthesized for each RF coil used for MR signal reception. A set of weights for signal synthesis has to be determined by fitting linear combinations of MR signals received via each RF coil to the acquired auto-calibration data. This process has to be repeated for each RF coil used for parallel image acquisition. Consequently, the computational complexity for MR image reconstruction scales with the number of RF coils used for signal acquisition. This is a serious limitation because presently a trend to use a large number of RF coils in parallel can be observed.

A further issue is that in GRAPPA imaging a MR image is reconstructed from the MR signal data received via each individual RF coil. These separate coil images are then combined via a sum-of-squares reconstruction to obtain a final composite MR image. A drawback of this procedure is that only a magnitude image is reconstructed and the phase information is lost.

The GRAPPA reconstruction approach is disclosed, for example, in US 6,841,998 B1.

From the foregoing it is readily appreciated that there is a need for an improved parallel MR imaging technique. It is consequently an object of the invention to enable fast parallel MR imaging at a reduced computational complexity.

In accordance with the invention, a method of MR imaging of an obj ect placed in an examination volume of a MR device is disclosed. The method comprises the steps of:

- subj ecting the obj ect to a first imaging sequence for acquiring a first signal data set, which first signal data set includes MR signals received via a volume RF coil having an essentially homogeneous spatial sensitivity profile within the examination volume, wherein the first imaging sequence comprises RF pulses and switched magnetic field gradients controlled in such a manner that only a central portion of k-space is sampled at a full sampling density;
- subj ecting the obj ect to a second imaging sequence for acquiring a second signal data set, which second signal data set includes MR signals received in parallel via a set of at least two array RF coils having different spatial sensitivity profiles within the examination volume, wherein the second imaging sequence comprises RF pulses and switched magnetic field gradients controlled in such a manner that peripheral and central portions of k-space are sampled at a reduced sampling density;
- deriving a set of weights from the first signal data set and the second signal data set;
- applying the set of weights for combining the MR signals received via the at least two array RF coils into a third signal data set in such a manner that the third signal data set covers the peripheral and central portions of the k-space at the full sampling density; and
- reconstructing a MR image from the third signal data set.

According to the invention, k-space is fully sampled only in its central portion and only via the volume RF coil, while the array RF coils are used for sampling the central and peripheral portions of k-space in a sub-sampled fashion, i.e. at a reduced sampling density. The set of weights required for synthesis of missing k-space data is derived from the data acquired via the volume RF coil and via the array RF coils. A third signal data set is synthesized from the sub-sampled MR signals received via the array RF coils, wherein the synthesized data covers the peripheral and central portions of k-space at the full sampling density. Finally, a MR image is reconstructed from the fully sampled synthesized data set.

One advantage of the method of the invention is that only one set of weights has to be derived. Hence, the computational complexity is much reduced as compared to the conventional GRAPPA approach. This leads to much faster MR image reconstruction.

A further advantage is that the phase information is fully preserved. This is because the MR signals received via the volume RF coil are used for derivation of the set of weights. Hence, there is no necessity to apply a sum-of-squares combination for reconstruction of the final MR image.

Yet another advantage of the invention is that the second signal data, i.e. the MR signals received in parallel via the array RF coils, do not include embedded auto-calibration data. Consequently, the signal data can be acquired by uniform sub-sampling of k-space having the advantage of a uniform eddy current response and smooth weighting by signal decay as compared to the variable density acquisition which is applied in GRAPPA imaging.

The method of the invention advantageously produces MR images at high acquisition and reconstruction speed in combination with high image quality and high signal-to noise ratio.

It has to be noted that the method steps of the invention do not necessarily have to be performed in the above consecutive order. For example, also an interleaved operating scheme, in which k-space lines are alternately acquired via the volume RF coil and the array RF coils, is feasible. Hence, the first and second signal data set may be acquired (at least in part) simultaneously according to the invention.

In accordance with the invention, k-space is sampled at a full sampling density during acquisition of the first signal data set. This means that the first signal data set fully covers a given field-of-view. During acquisition of the second signal data set the number of phase-encoding steps is reduced by a reduction factor R, typically by increasing the distance of equidistantly sampled k-space lines. This means that the second signal data set covers a reduced field-of-view which is smaller than the full field of view. In order to obtain the desired image resolution, both peripheral and central portions of k-space are sampled during acquisition of the second signal data set. During acquisition of the first signal data set, in contrast, only the central portion of k-space is sampled, which means that the first signal data set is acquired at a reduced resolution.

According to a preferred embodiment of the invention, the set of weights is derived by fitting linear combinations of MR signals of the second signal data set to MR signals of the first signal data set. This means that the set of weights is derived from a relationship between the MR signals of the second signal data set and the MR signals of the first signal data set. In this manner, linear combination weights are generated that are usable for synthesis of k-space data received via the volume RF coil from k-space data received via the array RF coils. The set of weights derived in this manner can then be applied to compute linear combinations of MR signals of the second signal data set so as to obtain MR signals of the third signal data set. In this way, a new fully sampled third data set is computed from the undersampled second data set, which results in a full-field of-view MR image after Fourier transformation.

The method of the invention described thus far can be carried out by means of a MR device including at least one main magnet coil for generating a uniform static magnetic field within an examination volume, a number of gradient coils for generating switched magnetic field gradients in different spatial directions within the examination volume, at least one volume RF coil which has an essentially homogeneous spatial sensitivity profile, for generating RF pulses within the examination volume and/or for receiving MR signals from an object positioned in the examination volume, a set of array RF coils for receiving MR signals from the body in parallel, the array RF coils having different spatial sensitivity profiles, a control unit for controlling the temporal succession of RF pulses and switched magnetic field gradients, and a reconstruction unit. The method of the invention can be implemented, for example, by a corresponding programming of the reconstruction unit and/or the control unit of the MR device.

The method of the invention can be advantageously carried out in most MR devices in clinical use at present. To this end it is merely necessary to utilize a computer program by which the MR device is controlled such that it performs the above-explained method steps of the invention. The computer program may be present either on a data carrier or be present in a data network so as to be downloaded for installation in the control unit of the MR device.

BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:

Fig. 1 shows a MR device for carrying out the method of the invention;
Fig. 2 shows a block diagram illustrating the method of the invention;
Fig. 3 shows a block diagram illustrating the computation of a set of weights according to the invention;
Fig. 4 shows a diagram illustrating the synthesis of missing k-space data according to the invention.

DETAILED DESCRIPTION OF EMBODIMENTS

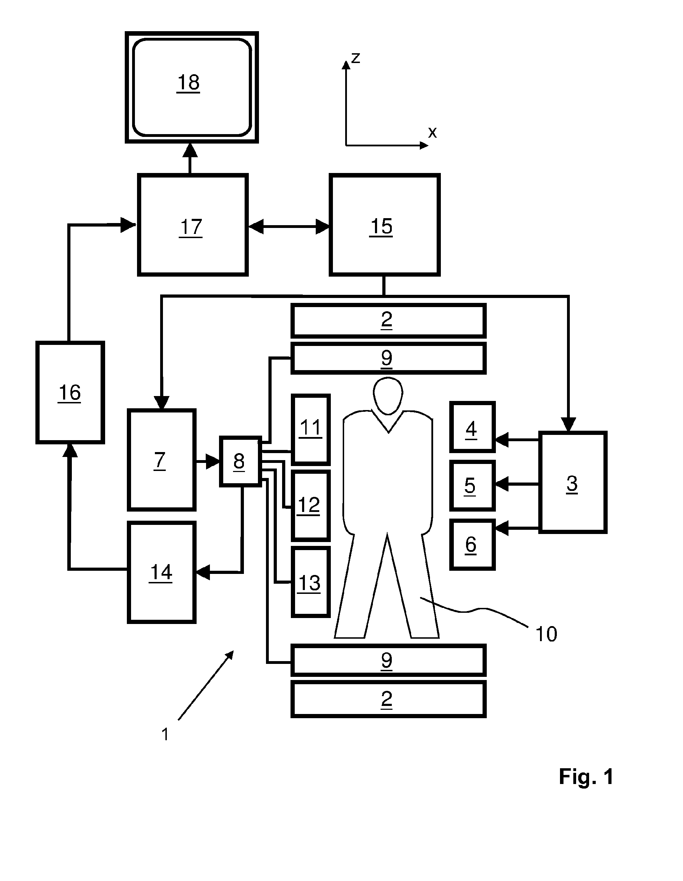

With reference to Figure 1, a MR device 1 is shown. The device comprises superconducting or resistive main magnet coils 2 such that a substantially uniform, temporally constant main magnetic field is created along a z-axis through an examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

Most specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send-/receive switch 8, to a whole-body volume RF coil 9 to transmit RF pulses into the examination volume. A typical MR imaging sequence is composed of a packet of RF pulse segments of short duration which taken together with each other and any applied magnetic field gradients achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the whole-body volume RF coil 9.

For generation of MR images of limited regions of the body 10 by means of parallel imaging, a set of local array RF coils 11, 12, 13 are placed contiguous to the region selected for imaging. The array coils 11, 12, 13 can be used to receive MR signals induced by body-coil RF transmissions.

The resultant MR signals are picked up by the whole body volume RF coil 9 and/or by the array RF coils 11, 12, 13 and demodulated by a receiver 14 preferably including a preamplifier (not shown). The receiver 14 is connected to the RF coils 9, 11, 12 and 13 via send-/receive switch 8.

A host computer 15 controls the gradient pulse amplifier 3 and the transmitter 7 to generate any of a plurality of MR imaging sequences, such as echo planar imaging (EPI), echo volume imaging, gradient and spin echo imaging, fast spin echo imaging, and the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. In modern MR devices the data acquisition system 16 is a separate computer which is specialized in acquisition of raw image data.

Ultimately, the digital raw image data is reconstructed into an image representation by a reconstruction processor 17 which applies a Fourier transform or other appropriate reconstruction algorithms. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor 18 which provides a man-readable display of the resultant MR image.

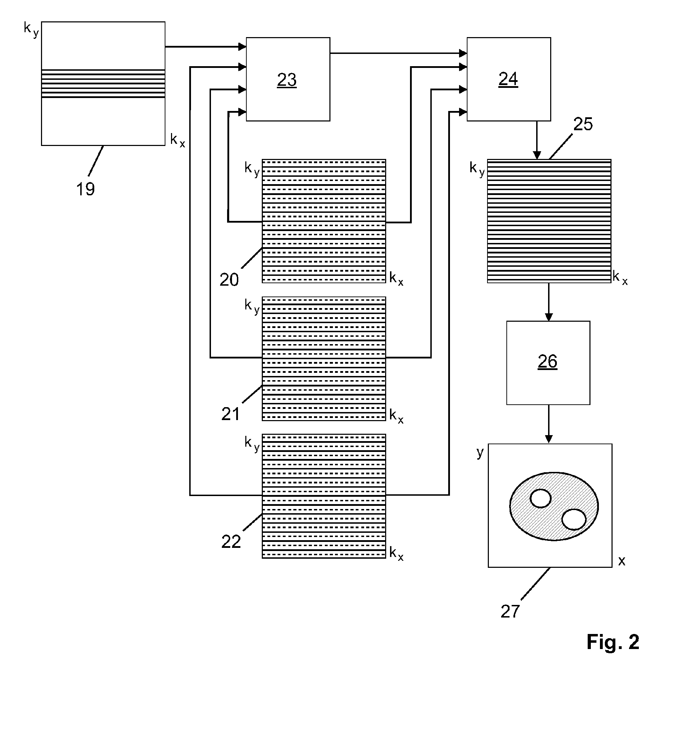

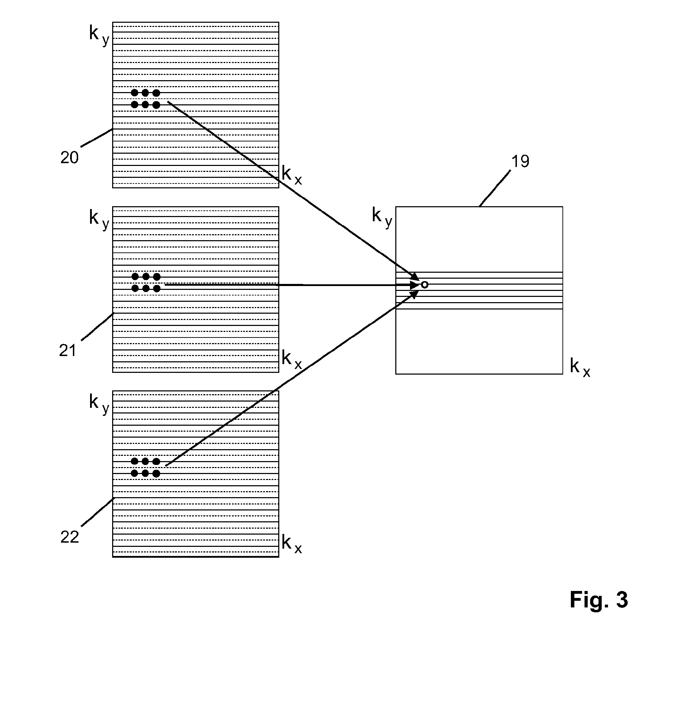

With continuing reference to Figure 1 and with further reference to Figures 2 and 3, an embodiment of the imaging approach of the invention is explained.

According to the invention, the portion of the body 10 is subjected to a first imaging sequence for acquiring a first signal data set 19. The first signal data set 19 includes MR signals received via the volume RF coil 9. As illustrated in Figure 2, only a central portion of k-space is sampled by means of the first imaging sequence. In the depicted embodiment the first signal data set 19 includes several k-space lines in the central portion of k-space that are equidistantly spaced in ky direction.

Moreover, the portion of the body 10 is subjected to a second imaging sequence for acquiring a second signal data set. The second signal data set includes sub-sets 20, 21, 22 of MR signal data received via the array RF coils 11, 12, 13, respectively. As can be seen in Figure 2, the second signal data set 20, 21, 22 covers both the central and peripheral portions of k-space. However, the second signal data set 20, 21, 22 is sampled at a reduced sampling density. In the depicted embodiment the second signal data set 20, 21, 22 is acquired at a reduction factor of R=2. The dashed lines in Figure 2 indicate k-space lines missing in the second signal data set 20, 21, 22.

A set of weights is derived from the first signal data set 19 and the second signal data set 20, 21, 22 by fitting linear combinations of MR signals of the second signal data set 20, 21, 22 to MR signals of the first signal data set 19 at k-space positions missing in the second signal data set. This is illustrated in Figure 3. The filled-out circles in the second signal data set 20, 21, 22 indicate acquired MR signals which are superposed by linear combination. The weights are determined by fitting this linear combination to MR signals of the first signal data set 19. The corresponding k-space position in the first signal data set 19 is indicated by the open circle in Figure 3. The fitting procedure has to be performed on the basis of a sufficient number of k-space positions in the first signal data set 19 and the second signal data set 20, 21, 22 so as to ensure that the inverse problem to be solved is not underdetermined. To this end the k-space positions are congruently shifted in the first signal data set 19 and the second signal data set 20, 21, 22. The combination of the weighted MR signals of the first signal data set 20, 21, 22 can be written as follows:

$$S^{(1)}(k) = \sum_{l=1}^{N_C} \sum_{i=1}^{N_k} n_{li} S^{(2)}{}_l(k_i)$$

Herein, $S^{(1)}(k)$ indicates a (complex) MR signal of the first signal data set 19, while $S^{(2)}{}_l(k_i)$ indicates a MR signal of the second signal data set 20, 21, 22 received via one of the array coils 11, 12, 13. $l=1..N_c$ is the index indicating the respective array RF coil. $N_c$ is the total number of array RF coils. The index $i=1..N_k$ represents the number of k-space positions within the second signal data set 20, 21, 22 used for the linear combination. In general, an arbitrary number of k-space positions in the neighborhood of the respective k-space position (open circle in Figure 3) within the first signal data set 19 can be selected. The number $N_k$ has to be selected so as to find a good compromise between computation speed and image quality. $n_{li}$ represents the set of weights. The weights $n_{li}$ are determined by means of a common least squares fitting algorithm. The step of computation of the set of weights is indicated by reference number 23 in Figure 2. In step 24 the set of weights is applied for combining the MR signals received via the array RF coils 11, 12, 13, i.e. the MR signals of the second signal data set 20, 21, 22, into a third signal data set 25. To this end, linear combinations of the MR signals of the second signal data set, 20, 21, 22 are computed so as to obtain the third signal data set 25 with full k-space coverage and at full k-space density. The synthesis of MR signals of the third signal data set 25 can be written as follows:

$$S^{(3)}(k) = \sum_{l=1}^{N_C} \sum_{i=1}^{N_k} n_{li} S^{(2)}{}_l(k_i)$$

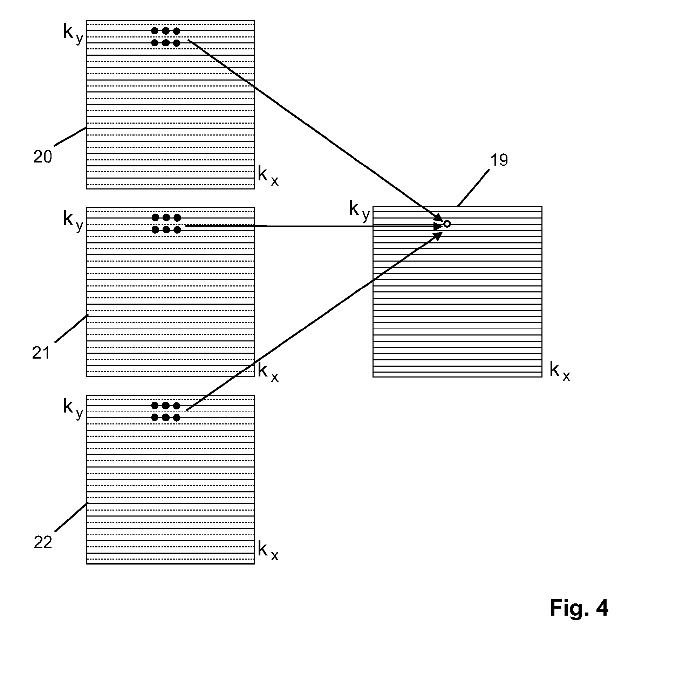

In this formula $S^{(3)}(k)$ represents a (complex) MR signal of the third signal data set 25. The data synthesis is illustrated in Figure 4. The filled-out circles again indicate k-space positions within the second signal data set 20, 21, 22 which are superposed in order to obtain k-space data at $k_y$ positions. Finally, a MR image 27 is reconstructed in a step 26, for example by means of Fourier transformation of the third signal data set 25.

It can be concluded that the method of the invention has the advantage that the computation time for the synthesis of the third data set scales linearly with the number of array RF coils used for MR signal acquisition since the method requires to estimate only one set of weights, and only one "target data set", i.e. the third signal data set 25 within the meaning of the invention, has to be synthesized. This leads to much faster reconstruction times in comparison to known approaches, such as GRAPPA. A further advantage is that phase information is preserved in the final MR image 27 because the first signal data set 19, i.e. the MR signals received via the volume RF coil 9, are used for deriving the set of weights. Also the acquisition time is reduced by the method of the invention because it is not necessary to fully sample the k-space center when acquiring the second signal data set 20, 21, 22, i.e. the MR data used for reconstruction of the final MR image 27. Moreover, the second signal data set 20, 21, 22 can be acquired by uniform sub-sampling of k-space (in the $k_y$ direction in the depicted embodiment ), which has the advantage of a more uniform eddy current response and smooth weighting by relaxation decay of the MR signal as compared to a variable k-space density acquisition.

**Claims**

1.  Method of MR imaging of an object (10) placed in an examination volume of a MR device (1), the method comprising the steps of

    - subjecting the object (10) to a first imaging sequence for acquiring a first signal data set (19), which first signal data set (19) includes MR signals received via a volume RF coil (9) having an essentially homogeneous spatial sensitivity profile within the examination volume, wherein the first imaging sequence comprises RF pulses and switched magnetic field gradients controlled in such a manner that only a central portion of k-space is sampled at a full sampling density;
    - subjecting the object (10) to a second imaging sequence for acquiring a second signal data set (20, 21, 22), which second signal data set (20, 21, 22) includes MR signals received in parallel via a set of at least two array RF coils (11, 12, 13) having different spatial sensitivity profiles within the examination volume, wherein the second imaging sequence comprises RF pulses and switched magnetic field gradients controlled in such a manner that peripheral and central portions of k-space are sampled at a reduced sampling density;

    - deriving a set of weights from the first signal data set (19) and the second signal data set (20, 21, 22);
    - applying the set of weights for combining the MR signals received via the at least two array RF coils (11, 12, 13) into a third signal data set (25) in such a manner that the third signal data set (25) covers the peripheral and central portions of k-space at the full sampling density; and
    - reconstructing a MR image (27) from the third signal data set (25).

2.  Method of claim 1, wherein the first signal data set covers a full field-of-view.

3.  Method of claim 2, wherein the second signal data set covers a reduced field-of-view which is smaller than the full field of view.

4.  Method of any one of claims 1-3, wherein the set of weights is derived by fitting linear combinations of MR signals of the second signal data set (20, 21, 22) to MR signals of the first signal data (19) at k-space positions missing in the second signal data set (20, 21, 22).

5.  Method of claim 4, wherein the set of weights is applied to compute linear combinations of MR signals of the second signal data set (20, 21, 22) so as to obtain MR signals of the third signal data set (25).

6.  MR device for carrying out the method claimed in claims 1-5, which MR device (1) includes at least one main magnet coil (2) for generating a uniform, static magnetic field within an examination volume, a number of gradient coils (4, 5, 6) for generating switched magnetic field gradients in different spatial directions within the examination volume, at least one volume RF coil (9), which has an essentially homogeneous spatial sensitivity profile, for generating RF pulses within the examination volume and/or for receiving MR signals from an object (10) positioned in the examination volume, a set of array RF coils (11, 12, 13) for receiving MR signals from the body (10) in parallel, the array RF coils (11, 12, 13) having different spatial sensitivity profiles, a control unit (15) for controlling the temporal succession of RF pulses and switched magnetic field gradients, and a reconstruction unit (17), wherein the MR device (1) is arranged to perform the following steps:

    - subjecting the object (10) to a first imaging sequence for acquiring a first signal data set (19), which first signal data set (19) includes MR signals received via the volume RF coil (9), wherein the first imaging sequence comprises RF pulses and switched magnetic field gradients controlled in such a manner that only a central portion of k-space is sampled at a full sampling density;
- subjecting the object (10) to a second imaging sequence for acquiring a second signal data set (20, 21, 22), which second signal data set (20, 21, 22) includes MR signals received in parallel via the set of array RF coils (11, 12, 13), wherein the second imaging sequence comprises RF pulses and switched magnetic field gradients controlled in such a manner that peripheral and central portions of k-space are sampled at a reduced sampling density;
- deriving a set of weights from the first signal data set (19) and the second signal data set (20, 21, 22);
- applying the set of weights for combining the MR signals received via the at least two array RF coils (11, 12, 13) into a third signal data set (25) in such a manner that the third signal data set (25) covers the peripheral and central portions of k-space at the full sampling density; and
- reconstructing a MR image (27) from the third signal data set (25).

7. MR device of claim 6, wherein the volume RF coil (9) is a body coil.

8. MR device of claim 6 or 7, wherein the array RF coils (11, 12, 13) are surface coils.

9. Computer program to be run on a MR device, which computer program comprises instructions for:

- generating a first imaging sequence for acquiring a first signal data set (19), wherein the first imaging sequence comprises RF pulses and switched magnetic field gradients controlled in such a manner that only a central portion of k-space is sampled at a full sampling density;
- generating a second imaging sequence for acquiring a second signal data set (20, 21, 22), wherein the second imaging sequence comprises RF pulses and switched magnetic field gradients controlled in such a manner that peripheral and central portions of k-space are sampled at a reduced sampling density;
- deriving a set of weights from the first signal data set (19) and the second signal data set (20, 21, 22);
- applying the set of weights for combining MR signals comprised in the second signal data set (20, 21, 22) into a third signal data set (25) in such a manner that the third signal data set (25) covers the peripheral and central portions of k-space at the full sampling density; and
- reconstructing a MR image (27) from the third signal data set (25).

**Fig. 1**

**Fig. 2**

Fig. 3

Fig. 4

# EP 2 581 756 A1

Europäisches
Patentamt
European
Patent Office
Office européen
des brevets

# EUROPEAN SEARCH REPORT

Application Number

EP 11 18 4643

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 7 492 153 B2 (BRAU ANJA C S [US] ET AL) 17 February 2009 (2009-02-17) * column 8, line 36 - column 9, paragraph 2; figure 6 * | 1-9 | INV. G01R33/561 |
| X | DAVID J LARKMAN ET AL: "INVITED TOPICAL REVIEW; Parallel magnetic resonance imaging", PHYSICS IN MEDICINE AND BIOLOGY, TAYLOR AND FRANCIS LTD. LONDON, GB, vol. 52, no. 7, 7 April 2007 (2007-04-07), pages R15-R55, XP020113275, ISSN: 0031-9155, DOI: 10.1088/0031-9155/52/7/R01 * page R25 - page R35; figure 10 * | 1-9 | |
| X | EP 1 102 076 A2 (MARCONI CASWELL LTD [GB]) 23 May 2001 (2001-05-23) * paragraph [0031] - paragraph [0039] * | 1-3,6-9 | |
| A | US 2008/012562 A1 (BEATTY PHILIP J [US]) 17 January 2008 (2008-01-17) * the whole document * | 1-9 | TECHNICAL FIELDS SEARCHED (IPC) G01R |
| A,D | US 6 841 998 B1 (GRISWOLD MARK [DE]) 11 January 2005 (2005-01-11) * the whole document * | 1-9 | |

The present search report has been drawn up for all claims

| Place of search | Date of completion of the search | Examiner |
|---|---|---|
| Munich | 16 February 2012 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.** EP 11 18 4643

This annex lists the patent family members relating to the patent documents cited in the above-mentioned European search report.
The members are as contained in the European Patent Office EDP file on
The European Patent Office is in no way liable for these particulars which are merely given for the purpose of information.

16-02-2012

| Patent document cited in search report | | Publication date | Patent family member(s) | | Publication date |
|---|---|---|---|---|---|
| US 7492153 | B2 | 17-02-2009 | NONE | | |
| EP 1102076 | A2 | 23-05-2001 | EP | 1102076 A2 | 23-05-2001 |
| | | | JP | 2001198108 A | 24-07-2001 |
| | | | US | 6396269 B1 | 28-05-2002 |
| US 2008012562 | A1 | 17-01-2008 | NONE | | |
| US 6841998 | B1 | 11-01-2005 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6841998 B1